# EUROPÄISCHE PATENTANMELDUNG

(11) **EP 3 654 533 A1**
(43) Veröffentlichungstag der Anmeldung: **20.05.2020**
(21) Anmeldenummer: 18206189.5
(22) Anmeldetag: 14.11.2018
(51) Int. Cl.: H03K 19/00, H03K 19/003

(54) **BEREITSTELLEN EINES STEUERSIGNALS FÜR EIN EINE SCHALTSTRECKE AUFWEISENDES SCHALTELEMENT**

(71) Anmelder: Siemens Aktiengesellschaft, 80333 München (DE); Karlsruher Institut für Technologie, 76131 Karlsruhe (DE)
(72) Erfinder: STAMER, Fabian, 76229 Karlsruhe (DE); HILLER, Marc, 75015 Bretten (DE)

(57) **Zusammenfassung**

Die Erfindung betrifft ein Verfahren zum Bereitstellen eines Steuersignals für ein eine Schaltstrecke aufweisendes Schaltelement (24), das einen elektrisch isolierenden Steueranschluss (46) zum Steuern der Schaltstrecke abhängig vom Steuersignal am Steueranschluss (46) aufweist, wobei das Steuersignal abhängig von einem Taktsignal für einen Schaltbetrieb des Schaltelements (24) an einem mit dem Steueranschluss (46) elektrisch gekoppelten ersten Anschluss eines Impedanzelements bereitgestellt wird, wobei das Impedanzelement eine elektrische Induktivität (L₁) aufweist und der zweite Anschluss des Impedanzelements mittels eines ersten Steuerschaltelements (T₁) abhängig von einem ersten Schaltsignal mit einem Einschaltpotential (50) beaufschlagt wird und der erste Anschluss des Impedanzelements mittels eines zweiten Steuerschaltelements (T₄) abhängig von einem zweiten Schaltsignal mit einem Ausschaltpotential (52) beaufschlagt wird, wobei das erste und das zweite Schaltsignal abhängig vom Taktsignal bereitgestellt werden.

## Beschreibung

Die Erfindung betrifft eine Treiberschaltung zum Bereitstellen eines Steuersignals für ein eine Schaltstrecke aufweisendes Schaltelement, das einen elektrisch isolierenden Steueranschluss zum Steuern der Schaltstrecke abhängig vom Steuersignal am Steueranschluss aufweist, wobei die Treiberschaltung ausgebildet ist, das Steuersignal abhängig von einem Taktsignal eines Taktgebers für einen Schaltbetrieb des Schaltelements bereitzustellen, zu welchem Zweck die Treiberschaltung ein Impedanzelement aufweist, das einen ersten Anschluss zum Bereitstellen des Steuersignals und einen zweiten Anschluss aufweist. Die Erfindung betrifft ferner einen Energiewandler zum Wandeln von elektrischer Energie, mit wenigstens einem elektrischen Wandlerspeicher, wenigstens einem eine Schaltstrecke aufweisenden Schaltelement, das einen elektrisch isolierenden Steueranschluss zum Steuern der Schaltstrecke abhängig von einem Steuersignal am Steueranschluss aufweist und das mit dem wenigstens einen Wandlerspeicher elektrisch gekoppelt ist, einem Taktgeber zum Bereitstellen eines Taktsignals für einen Schaltbetrieb des wenigstens einen Schaltelements und einer an den Steueranschluss angeschlossenen und mit dem Taktgeber elektrisch gekoppelten Treiberschaltung, die ausgebildet ist, das Steuersignal abhängig vom Taktsignal bereitzustellen. Schließlich betrifft die Erfindung auch ein Verfahren zum Bereitstellen eines Steuersignals für ein eine Schaltstrecke aufweisendes Schaltelement, das einen elektrisch isolierenden Steueranschluss zum Steuern der Schaltstrecke abhängig vom Steuersignal am Steueranschluss aufweist, wobei das Steuersignal abhängig von einem Taktsignal für einen Schaltbetrieb des Schaltelements an einem mit dem Steueranschluss elektrisch gekoppelten ersten Anschluss eines Impedanzelements bereitgestellt wird. Treiberschaltungen, Energiewandler mit derartigen Treiberschaltungen sowie Verfahren zu deren Betrieb sind im Stand der Technik umfänglich bekannt. Ein Schaltelement im Sinne dieser Offenbarung ist dabei vorzugsweise ein steuerbares elektronisches Schaltelement, insbesondere ein Transistor, der in einem Schaltbetrieb betrieben wird, vorzugsweise mit einer parallelgeschalteten Inversdiode, beispielsweise ein Insulated-Gate-Bipolar-Transistor (IGBT), ein Metalloxide-Semiconductor-Field-Effect-Transistor (MOSFET) aber auch ein Feldeffekttransistor wie ein Sperrschichtfeldeffekttransistor oder dergleichen. Derartige Schaltelemente zeichnen sich dadurch aus, dass sie einen Steueranschluss aufweisen, der von den weiteren elektrischen Anschlüssen des Schaltelements, insbesondere den Anschlüssen, die an die Schaltstrecke angeschlossen sind, elektrisch isolierend ausgebildet ist. Der Steueranschluss wird häufig auch Gate-Anschluss genannt. Die elektrische Isolation kann durch eine Isolationsschicht, eine in Sperrrichtung mit einer entsprechenden elektrischen Spannung beaufschlagte Sperrschicht oder dergleichen sein.

Derartige Transistoren werden im Stand der Technik für die unterschiedlichsten Anwendungen im Schaltbetrieb genutzt. Für ein gattungsgemäßes Schaltelement bedeutet dies, dass in einem eingeschalteten Schaltzustand zwischen den die Schaltstrecke bildenden Anschlüssen des Schaltelements ein sehr kleiner elektrischer Widerstand bereitgestellt wird, sodass ein hoher Stromfluss bei sehr kleiner Restspannung möglich ist. In einem ausgeschalteten Schaltzustand ist hingegen die Schaltstrecke des Schaltelements hochohmig, das heißt, sie stellt einen hohen elektrischen Widerstand bereit, sodass auch bei hoher, an der Schaltstrecke anliegender elektrischer Spannung im Wesentlichen kein oder nur ein sehr geringer, insbesondere vernachlässigbarer, Stromfluss vorliegt. Hiervon unterscheidet sich ein Linearbetrieb bei Transistoren, der aber bei Einsatz der Transistoren im Schaltbetrieb in der Regel nicht zum Einsatz kommt.

Derartige Schaltelemente finden insbesondere Einsatz bei elektrischen Energiewandlern, beispielsweise DC/DC-Wandlern wie Hochsetzstellern (Booster), Tiefsetzstellern (Buck), aber auch bei Wechselrichtern sowie anderen elektrischen Energiewandlern, beispielsweise bei einem dreiphasigen Zweipunktstromrichter mit drei Netzinduktivitäten und sechs Schaltelementen, die als IGBT ausgebildet sein können. Ihre Schaltfunktionalität wird insbesondere bei Energiewandlern dazu genutzt, mit einem elektrischen Wandlerspeicher, beispielsweise einer Induktivität und/oder einer elektrischen Kapazität, zusammenzuwirken, um auf diese Weise die Wandlungsfunktionalität des Energiewandlers realisieren zu können. Zu diesem Zweck umfasst der Energiewandler in der Regel einen Taktgeber, der ein Taktsignal bereitstellt, aus welchem das Steuersignal für das Schaltelement erzeugt werden kann. Das Taktsignal ist ein Signal, welches entsprechend der durch das Schaltelement bereitzustellenden Schaltzustände Taktsignalpegel aufweisen kann. Vorzugsweise sind dies wenigstens zwei voneinander unterschiedliche Signalpegel, die den jeweiligen Schaltzuständen des Schaltelements zugeordnet sind. Das Taktsignal kann beispielsweise ein Rechtecksignal sein.

Zum Erzeugen des Steuersignals aus dem Taktsignal wird in der Regel eine Treiberschaltung genutzt, die im Stand der Technik auch gelegentlich als Gate-Ansteuerung bezeichnet wird. Die Treiberschaltung dient vorzugsweise dazu, das Steuersignal abhängig vom Taktsignal derart bereitzustellen, dass das Schaltelement den gewünschten aktuellen Schaltzustand gemäß dem aktuellen Signalpegel des Taktsignals einnimmt. Mittels der Treiberschaltung kann das Schaltelement in den eingeschalteten und den ausgeschalteten Schaltzustand versetzt werden.

Aufgrund des physikalischen Aufbaus des Schaltelements weist der Steueranschluss eine elektrische Kapazität auf, die in der Regel bei einem Wechsel des Schaltzustands umzuladen ist. Diese Kapazität wird auch Gate-Kapazität genannt. Aus diesem Grund ist die Treiberschaltung üblicherweise dazu ausgelegt, die Gate-Kapazität des Steueranschlusses des Schaltelements aufzuladen sowie auch zu entladen. Eine solche Treiberschaltung basiert im Grundprinzip also darauf, den Steueranschluss mit einer Spannungsquelle zu verbinden, damit der Steueranschluss mit einem vorgegebenen elektrischen Potential beaufschlagt wird, um den gewünschten Schaltzustand des Schaltelements realisieren zu können. Dabei wird der Steueranschluss in Bezug auf eine mit der Schaltstrecke verbundene Bezugselektrode des Schaltelements - bei einem IGBT ein Emitteranschluss, bei einem MOSFET ein Source-Anschluss - mit einer geeigneten elektrischen Spannung beaufschlagt, um den gewünschten Schaltzustand des Schaltelements zu realisieren, beispielsweise eine positive elektrische Spannung zum Einschalten des Schaltelements sowie eine negative elektrische Spannung oder null zum Abschalten des Schaltelements.

Ein Schaltverhalten des Schaltelements ist davon abhängig, auf welche Weise die jeweilige Gate-Kapazität umgeladen werden kann. Die Treiberschaltung ist demnach ein wichtiges Element zur Beeinflussung eines Schaltverhaltens des Schaltelements. Dies wird zum Beispiel im Applikationshandbuch Leistungshalbleiter der Semicon International GmbH, 2010, erläutert. Darüber hinaus führt hierzu auch Winter Schmitt aus, und zwar in "Ansteuerung von Hochvolt-IGBTs über optimierte Gatestromprofile", Dissertation Wuppertal 2009.

Im Stand der Technik ist eine Mehrzahl von unterschiedlichen Treiberschaltungen bekannt, welche sich in ihrer Charakteristik bezüglich der Einstellbarkeit der Schalteigenschaften des Schaltelements unterscheiden. Hierbei gibt es beispielsweise resistive Ansteuerungen, die unter Nutzung eines elektrischen Widerstands die Gate-Kapazität aufladen beziehungsweise entladen. Dabei können die Schalteigenschaften des Schaltelements durch ein Verhältnis einer eingesetzten Spannungsquelle und einem Widerstandswert des Widerstands beeinflusst werden.

Eine Weiterbildung der vorgenannten resistiven Ansteuerung ist eine sogenannte gesteuerte Ansteuerung, auch Open-Loop genannt. Um während des Betriebs des Schaltelements dessen Eigenschaften verändern zu können, wird ein sogenanntes Widerstands-Array eingesetzt, welches es erlaubt, unterschiedliche Widerstandswerte für einen jeweiligen Schaltvorgang auswählen zu können. Somit ist es möglich, die Schalteigenschaften des Schaltelements während des bestimmungsgemäßen Betriebs zu verändern, indem eine angepasste Ladekurve beziehungsweise Entladekurve in Bezug auf die Gate-Kapazität erzeugt wird. Je mehr Widerstandsstufen eingesetzt werden, umso mehr unterschiedliche Schalteigenschaften können realisiert werden.

Darüber hinaus gibt es auch sogenannte geregelte Ansteuerungen, auch Closed-Loop genannt. Hierbei ist die Treiberschaltung ausgebildet, ein geregeltes Schalten zu ermöglichen, zu welchem Zweck das Prinzip eines geschlossenen Regelkreises genutzt wird. Dies ist zum Beispiel ausgeführt von Christoph Dörlemann, in einer Dissertation "Geregelte Ansteuerung von Insulated Gate Bipolar Transistoren (IGBT)", Dissertation Bochum 2002.

Eine weitere Möglichkeit der Realisierung von Treiberschaltungen, die spezifisch bei einem MOSFET zum Einsatz kommen kann, basiert auf einer resonanten Ansteuerung des MOSFET. Hierzu wird das Prinzip eines parallelen oder auch eines Serienschwingkreises genutzt, wobei neben der Gate-Kapazität auch eine Gate-Induktivität zum Einsatz kommt. Hierzu wird in "Study on resonant gate driver circuits for high frequency application", Jaya Venkata Phani Sekhar Chennu, ICPS 2016, New Delhi, India, ausgeführt. Wilson Eberle beschreibt darüber hinaus in "A new resonant gate-drive circuit with efficient energy recovery and low conduction loss" in IEEE 2008 eine Topologie einer Vollbrücke. Eine spezifische, insbesondere einstellbare Ausschaltcharakteristik kann hierbei jedoch in der Regel nicht realisiert werden.

Die gesteuerte Ansteuerung ist zum Beispiel beschrieben in "An improved method of controlling IGBT modules using an optimized gate current waveform" von Marius Cenusa, CIPS 2014, Nürnberg, Deutschland. Danach ist es ermöglich, die Schalteigenschaften im bestimmungsgemäßen Betrieb zu beeinflussen; allerdings ist es nur möglich, aus zuvor ausgewählten Stufen zu wählen. Hierbei kann lediglich eine begrenzte Anzahl von Möglichkeiten realisiert werden. Es ist nämlich zu beachten, dass mit der Anzahl der Stufen auch mehr Bauteile und mehr Platz benötigt werden, wodurch Kosten und auch die Zuverlässigkeit beeinträchtigt werden.

Die geregelte Ansteuerung ermöglicht es zwar, das Problem der Anzahl von schaltbaren Stufen bei der gesteuerten Ansteuerung zu vermeiden, jedoch ist zur Realisierung eines geeigneten Regelkreises ein hoher Bauteileaufwand nötig, was ebenfalls zu hohen Kosten führt. Darüber hinaus sind die für eine entsprechend analoge Regelung erforderlichen Messschaltungen anfällig für Störungen, die zu weiteren aufwendigen Schaltungen führen, so wie zum Beispiel ausgeführt in "Active current source IGBT gate driver with closed-loop di/dt and dv/dt control" von Lu Shu, IEEE 2017 oder in "Optimized dv/dt, di/dt sensing for digitally controlled slope shaping gate driver" von Johannes Groeger, APEC 2017, Tampa, USA.

Es verbleibt weiterhin Verbesserungsbedarf bezüglich des Ansteuerns des Schaltelements.

Der Erfindung liegt somit die Aufgabe zugrunde, ein Verfahren zum Bereitstellen des Steuersignals sowie auch eine Treiberschaltung und einen Energiewandler mit einer Treiberschaltung bereitzustellen, bei denen eine hochflexible Steuerung des Schaltverhaltens des Schaltelements mit möglichst geringem Aufwand erreicht werden kann.

Als Lösung werden mit der Erfindung eine Treiberschaltung, ein Energiewandler sowie ein Verfahren gemäß den unabhängigen Ansprüchen vorgeschlagen.

Vorteilhafte Weiterbildungen ergeben sich durch Merkmale der abhängigen Ansprüche.

Bezüglich einer gattungsgemäßen Treiberschaltung wird insbesondere vorgeschlagen, dass das Impedanzelement eine elektrische Induktivität aufweist und dass die Treiberschaltung ein erstes und ein zweites Steuerschaltelement aufweist und ausgebildet ist, den zweiten Anschluss des Impedanzelements mittels des ersten Steuerschaltelements abhängig von einem ersten von dem Taktsignal abhängigen Schaltsignal mit einem Einschaltpotential zu beaufschlagen und den ersten Anschluss des Impedanzelements mittels des zweiten Steuerschaltelements abhängig von einem zweiten von dem Taktsignal abhängigen Schaltsignal mit einem Ausschaltpotential zu beaufschlagen.

Bezüglich eines gattungsgemäßen Energiewandlers wird insbesondere vorgeschlagen, dass dieser eine Treiberschaltung gemäß der Erfindung aufweist.

Bezüglich eines gattungsgemäßen Verfahrens wird insbesondere vorgeschlagen, dass das Impedanzelement eine elektrische Induktivität aufweist und dass der zweite Anschluss des Impedanzelements mittels eines ersten Steuerschaltelements abhängig von einem ersten Schaltsignal mit einem Einschaltpotential beaufschlagt wird und der erste Anschluss des Impedanzelements mittels eines zweiten Steuerschaltelements abhängig von einem zweiten Schaltsignal mit einem Ausschaltpotential beaufschlagt wird, wobei das erste und das zweite Schaltsignal abhängig vom Taktsignal bereitgestellt werden.

Die Erfindung basiert auf der Erkenntnis, dass die Schalteigenschaften des Schaltelements davon abhängig sind, auf welche Weise, insbesondere mit welcher Geschwindigkeit, die Gate-Kapazität entsprechend umgeladen wird, um den Schaltzustand des Schaltelements zu wechseln. Dabei nutzt die Erfindung den Gedanken, dass die Eigenschaften des Umladens der Gate-Kapazität beziehungsweise der Kapazität des elektrisch isolierenden Steueranschlusses des Schaltelements mittels eines Energiespeichers unterstützt beziehungsweise gesteuert werden kann, der in vorgebbarer Weise Energie speichert und diese für das Umladen der Gate-Kapazität zur Verfügung stellt. Vorliegend ist dieser Energiespeicher durch die Induktivität gebildet, die zugleich auch vom Impedanzelement umfasst ist, insbesondere durch das Impedanzelement gebildet ist.

Dadurch ist es möglich, die Induktivität mittels des ersten und des zweiten Steuerschaltelements in vorgebbarer Weise mit dem Einschaltpotential und dem Ausschaltpotential zu verbinden, sodass die Induktivität eine vorgebbare Energiemenge zu speichern vermag, wobei dann durch geeignetes Schalten des ersten und des zweiten Schaltelements diese Energie für das Umladen der Gate-Kapazität zur Verfügung gestellt werden kann. Dadurch ist es möglich, eine Vielzahl von unterschiedlichen Profilen beziehungsweise Charakteristiken bezüglich des Umladens der Gate-Kapazität zu erzeugen, sodass die Schalteigenschaften des Schaltelements auch während des bestimmungsgemäßen Schaltbetriebs des Schaltelements nahezu beliebig geändert werden können. Dieser Effekt kann grundsätzlich sowohl für das Wechseln vom ausgeschalteten Schaltzustand in den eingeschalteten Schaltzustand als auch umgekehrt oder in beiden Fällen genutzt werden, wie im Folgenden noch weiter erläutert werden wird.

Dem Grunde nach kann die Induktivität mit Energie derart aufgeladen werden, dass die Energie für einen vollständigen Umladungsvorgang der Gate-Kapazität ausreicht. Es kann darüber hinaus jedoch auch vorgesehen sein, dass sie lediglich einen Teil der hierfür erforderlichen Energiemenge bereitstellt. Etwaige fehlende Energie kann dann vorzugsweise einer Steuerenergiequelle entnommen werden.

Die Treiberschaltung wird vorzugsweise von einer Steuerenergiequelle mit elektrischer Energie versorgt. Die Steuerenergiequelle stellt zu diesem Zweck zumindest zwei elektrische Potentiale bereit, nämlich das Einschaltpotential und das Ausschaltpotential. Bei diesen Potentialen handelt es sich um elektrische Potentiale, die, wenn der Steueranschluss mit diesen Potentialen beaufschlagt ist, einen entsprechenden Schaltzustand des Schaltelements zur Folge haben. So kann das Schaltelement beispielsweise im eingeschalteten Schaltzustand sein, wenn die Steuerelektrode mit dem Einschaltpotential beaufschlagt ist. Dagegen kann das Schaltelement im ausgeschalteten Schaltzustand sein, wenn der Steueranschluss mit dem Ausschaltpotential beaufschlagt ist. Die Potentialdifferenz zwischen dem Einschaltpotential und dem Ausschaltpotential ist vorzugsweise derart ausgebildet, dass eine elektrische Isolation des Steueranschlusses des Schaltelements im bestimmungsgemäßen Betrieb nicht beschädigt wird. Bei einem handelsüblichen IGBT oder MOSFET beträgt diese Spannungsdifferenz der Steuerspannungsquelle beispielsweise 15 V oder auch 20 V, wobei das Ausschaltpotential dann einem Bezugspotential eines Bezugsanschlusses des Schaltelements entspricht, oder sie kann zum Beispiel 30 V betragen, wobei dann das Einschaltpotential und das Ausschaltpotential vorzugsweise symmetrisch zum elektrischen Potential des Bezugsanschlusses des Schaltelements sind. Auch andere, abweichende Potentiale können je nach Bedarf und Eigenschaften des Schaltelements, insbesondere seines Steueranschlusses, gewählt werden.

Die Treiberschaltung ist vorzugsweise als elektronische Hardwareschaltung ausgebildet. Sie kann darüber hinaus aber auch eine Rechnereinheit umfassen oder sogar durch diese gebildet sein. Die Treiberschaltung weist vorzugsweise einen Schaltelementanschluss auf, an dem das Steuersignal für den Steueranschluss des Schaltelements bereitgestellt wird. Der Schaltelementanschluss der Treiberschaltung kann somit vorzugsweise unmittelbar an den Steueranschluss des Schaltelements angeschlossen sein.

Darüber hinaus kann die Treiberschaltung an die Steuerspannungsquelle angeschlossen sein. Die Treiberschaltung kann aber auch eine eigene Steuerspannungsquelle aufweisen. Die entsprechenden Ausgestaltungen sind von der jeweiligen Schaltungstopologie und Anwendung abhängig.

Darüber hinaus weist die Treiberschaltung vorzugsweise einen Taktanschluss auf, mit dem die Treiberschaltung mit einem Taktgeber elektrisch gekoppelt werden kann, sodass die Treiberschaltung mit dem für das an ihr angeschlossenen Schaltelement zugeordneten Taktsignal beaufschlagt werden kann.

Der Taktgeber dient zum Bereitstellen des Taktsignals für den Schaltbetrieb des Schaltelements. Das Taktsignal kann zum Beispiel ein rechteckförmiges Signal sein, welches nach Art von Pulsweitenmodulation (PWM) moduliert ist oder dergleichen. Der Taktgeber kann von einer übergeordneten Steuerung bereitgestellt werden, die bei einem Energiewandler zum Beispiel von seiner Steuereinheit umfasst sein kann.

Dem Grunde nach kann die Treiberschaltung dazu ausgebildet sein, das Steuersignal für ein einziges Schaltelement bereitzustellen. Es kann darüber hinaus jedoch auch vorgesehen sein, dass die Treiberschaltung ausgebildet ist, für zwei oder mehrere Schaltelemente, vorzugsweise unabhängig voneinander, die jeweiligen Steuersignale bereitzustellen. Besonders vorteilhaft kann die Treiberschaltung dazu ausgebildet sein, die Steuersignale für in Reihe geschaltete Schaltelemente bereitzustellen. Hierzu kann die Treiberschaltung eine entsprechende Potentialanpassung beziehungsweise auch eine Potentialtrennung bezüglich der Steuersignale vorsehen.

Das Steuersignal ist ein elektrisches Signal, welches in der Regel in Form einer Steuerspannung bereitgestellt wird. Vorzugsweise ist ein maximales Potential der Steuerspannung das Einschaltpotential und ein minimales Potential der Steuerspannung das Ausschaltpotential. Dem Grunde nach können hier jedoch auch gegebenenfalls Abweichungen hiervon auftreten, die je nach Funktionalität mittels der Treiberschaltung der Erfindung realisiert werden können. Die Treiberschaltung stellt die Steuerspannung des Steuersignals in geeigneter Weise für den Steueranschluss des Schaltelements zur Verfügung. Um dies zu gewährleisten, kann vorgesehen sein, dass die Treiberschaltung an das Bezugspotential des Bezugsanschlusses des Schaltelements angeschlossen ist.

Mit der Erfindung ist es somit insbesondere möglich, in Bezug auf das Schaltelement beispielsweise eine Spannungsänderungsgeschwindigkeit und/oder Stromänderungsgeschwindigkeit anzupassen. Zu diesem Zweck kann zum Beispiel eine Flankensteilheit der Steuerspannung beeinflusst werden, die beim Wechsel zwischen den Schaltzuständen des Schaltelements bei der Steuerspannung entsprechend auftritt. Insbesondere ist es möglich, die Flankensteilheit mittels des Energieinhalts der Induktivität einzustellen. Der Energieinhalt der Induktivität kann durch geeignetes Steuern des ersten und des zweiten Steuerschaltelements entsprechend eingestellt werden. Für jeden einzelnen Schaltvorgang besteht somit die Möglichkeit, die Schaltcharakteristik, insbesondere die Flankensteilheit des Steuersignals beziehungsweise der Steuerspannung, entsprechend anzupassen. Zu diesem Zweck können zum Beispiel Schaltzeiten des ersten und des zweiten Schaltsignals in geeigneter Weise angepasst werden, sodass der gewünschte Energieinhalt in der Induktivität für einen jeweiligen Schaltvorgang eingestellt werden kann. Dadurch ist es möglich, die Schalteigenschaften des Schaltelements insbesondere auch während des bestimmungsgemäßen Betriebs, nämlich des Schaltbetriebs, nahezu stufenlos zu verändern.

Das Impedanzelement braucht dem Grunde nach nicht nur genau eine einzige elektrische Induktivität, beispielsweise in Form einer elektronischen Spule oder dergleichen, aufzuweisen. Es können auch zwei oder mehrere elektrische Induktivitäten vorgesehen sein, die durch das Impedanzelement umfasst sind, und die je nach Bedarf in geeigneter Weise elektrisch miteinander verschaltet sind, beispielsweise in Reihe oder parallel oder dergleichen. Darüber hinaus kann das Impedanzelement natürlich auch weitere elektronische Bauteile umfassen, beispielsweise einen oder mehrere elektrische Widerstände oder dergleichen. Diese können mit der Induktivität ebenfalls in geeigneter Weise verschaltet sein, um gewünschte Eigenschaften erreichen zu können. Dem Grunde nach kann zwar auch eine elektronische Kapazität vom Impedanzelement umfasst sein, jedoch sollte hierbei beachtet werden, dass möglichst keine unerwünschte Schwingneigung entsteht. Bevorzugt besteht deshalb das Impedanzelement lediglich aus einer oder mehreren Induktivitäten.

Die Steuerschaltelemente der Treiberschaltung können ebenfalls vorzugsweise durch Transistoren gebildet sein. Die Transistoren können als bipolare Transistoren oder auch als Feldeffekttransistoren, insbesondere Sperrschichtfeldeffekttransistoren, ausgebildet sein. Besonders vorteilhaft sind die Steuerschaltelemente zumindest teilweise durch MOSFET oder IGBT gebildet. Die Schaltsignale für die Steuerschaltelemente sind entsprechend des ausgewählten Typs von Transistoren angepasst bereitgestellt und werden von einem Schaltsignalgenerator, der vorzugsweise auch von der Treiberschaltung umfasst ist, bereitgestellt.

Der Schaltsignalgenerator erzeugt die Schaltsignale für die Steuerschaltelemente abhängig vom Taktsignal, welches der Treiberschaltung zur Verfügung steht. Der Schaltsignalgenerator kann durch eine elektronische Hardwareschaltung, eine Rechnereinheit sowie auch eine Kombination hiervon gebildet sein. Der Schaltsignalgenerator ist beispielsweise von der Treiberschaltung umfasst. Er kann jedoch zumindest teilweise auch vom Taktgenerator oder der übergeordneten Steuerung umfasst sein.

Darüber hinaus kann die Treiberschaltung einen Energiesteueranschluss aufweisen, der ein Energiesteuersignal für den Schaltsignalgenerator bereitstellt. Das Energiesteuersignal kann dazu dienen, den Energieinhalt der Induktivität einzustellen, indem der Schaltsignalgenerator dieses Energiesteuersignal auswertet und die Schaltsignale für die Steuerschaltelemente in geeigneter Weise ergänzend abhängig vom Taktsignal erzeugt. Dies kann mittels einer geeignet ausgebildeten Auswerteeinheit erfolgen, die vorzugsweise von der Treiberschaltung umfasst ist. Das Energiesteuersignal kann zum Beispiel von einer übergeordneten Steuerung, beispielsweise einer Steuereinrichtung des Energiewandlers oder dergleichen, bereitgestellt werden. Mittels des Energiesteuersignals können somit die Schalteigenschaften des Schaltelements beeinflusst werden.

Es kann beispielsweise vorgesehen sein, dass zum Wechseln vom ausgeschalteten Schaltzustand in den eingeschalteten Schaltzustand des Schaltelements zunächst entsprechend des Taktsignals die Schaltsignale für die beiden Steuerschaltelemente derart bereitgestellt werden, dass beide Steuerschaltelemente im Wesentlichen zugleich eingeschaltet werden, wodurch am Steueranschluss des Schaltelements zunächst noch das Ausschaltpotential anliegt. Sobald die Induktivität die vorgegebene Energiemenge enthält, kann dann das zweite Steuerschaltelement abgeschaltet werden, wobei das erste Schaltelement weiterhin eingeschaltet bleibt, sodass die Energie der Induktivität dem Steueranschluss des Schaltelements zur Verfügung gestellt wird. Dadurch kann ein rasches Umladen der Gate-Kapazität erreicht werden. Dadurch, dass das erste Steuerschaltelement weiterhin eingeschaltet bleibt, ist sichergestellt, dass während des eingeschalteten Schaltzustands des Schaltelements am Steueranschluss permanent das Einschaltpotential zuverlässig anliegt. Durch das Abschalten des zweiten Steuerschaltelements wird hier also der Einschaltvorgang des Schaltelements gestartet.

Der Wandlerspeicher ist vorzugsweise ein elektrisches Bauteil, welches dem Zwischenspeichern von elektrischer Energie bei einem bestimmungsgemäßen Betrieb von Energiewandlern dient. Der Wandlerspeicher kann eine oder mehrere Induktivitäten, eine oder mehrere Kapazitäten, Kombinationen hiervon oder dergleichen umfassen. Der Wandlerspeicher wirkt zum Wandeln von elektrischer Energie vorzugsweise mit dem wenigstens einen Schaltelement des Energiewandlers zusammen.

Es wird ferner vorgeschlagen, dass der erste Anschluss des Impedanzelements mittels eines dritten Steuerschaltelements abhängig von einem dritten vom Taktsignal abhängigen Schaltsignal mit dem Einschaltpotential beaufschlagt wird.

Darüber hinaus kann vorgesehen sein, dass die Treiberschaltung ein drittes Steuerschaltelement aufweist, wobei die Treiberschaltung ausgebildet ist, den ersten Anschluss des Impedanzelements mittels des dritten Steuerschaltelements abhängig von einem dritten vom Taktsignal abhängigen Schaltsignal mit dem Einschaltpotential zu beaufschlagen. Durch diese Ausgestaltung kann erreicht werden, dass der Steueranschluss des Schaltelements, insbesondere im eingeschalteten Schaltzustand, unmittelbar mit dem Einschaltpotential der Steuerspannungsquelle gekoppelt werden kann. Darüber hinaus können jedoch auch noch weitere Funktionalitäten im Zusammenhang mit weiteren Schaltelementen erreicht werden, wie sich im Folgenden noch ergibt.

Weiterhin wird vorgeschlagen, dass der zweite Anschluss des Impedanzelements mittels eines vierten Steuerschaltelements abhängig von einem vierten vom Taktsignal abhängigen Schaltsignal mit dem Ausschaltpotential beaufschlagt wird.

Für die Treiberschaltung wird gemäß einer Weiterbildung vorgeschlagen, dass die Treiberschaltung ein viertes Steuerschaltelement aufweist, wobei die Treiberschaltung ausgebildet ist, den zweiten Anschluss des Impedanzelements mittels des vierten Steuerschaltelements abhängig von einem vierten vom Taktsignal abhängigen Schaltsignal mit dem Ausschaltpotential zu beaufschlagen. Durch diese Weiterbildung kann erreicht werden, dass die Gate-Kapazität nur mit der Energie aufgeladen wird, die durch die Induktivität bereitgestellt wird. So kann zum Beispiel vorgesehen sein, dass, sobald die Induktivität den vorgegebenen Energieinhalt aufweist, das erste und das zweite Schaltelement abgeschaltet werden, wobei dann das dritte Schaltelement eingeschaltet wird, sodass die in der Induktivität enthaltene Energie, und zwar nur diese Energie, für das Umladen der Gate-Kapazität genutzt wird.

Darüber hinaus besteht die Möglichkeit, zusammen mit dem dritten Schaltelement eine vergleichbare Funktionalität zum Wechseln des Schaltelements vom eingeschalteten Schaltzustand in den ausgeschalteten Schaltzustand zu realisieren. Zu diesem Zweck sind das erste und das zweite Steuerschaltelement dann im ausgeschalteten Schaltzustand, wobei das dritte und das vierte Steuerschaltelement im eingeschalteten Schaltzustand sind, um die Induktivität auf einen vorgegebenen Energieinhalt aufzuladen. Sobald die vorgegebene Energiemenge durch die Induktivität erreicht ist, wird dann das dritte Steuerschaltelement ausgeschaltet, wobei das vierte Steuerschaltelement weiterhin eingeschaltet bleibt. Die in der Induktivität enthaltene Energie steht dann zum Umladen der Gate-Kapazität zur Verfügung, sodass die Gate-Kapazität des Schaltelements in vorgebbarer Weise umgeladen werden kann, damit das Schaltelement den ausgeschalteten Schaltzustand einnimmt. Hier kann also der Ausschaltvorgang des Schaltelements zum Beispiel durch Ausschalten des dritten Steuerschaltelements gestartet werden.

Sind vier Steuerschaltelemente in der vorgenannten Art und Weise vorhanden, kann zusammen mit der Induktivität eine H-Brückenschaltung gebildet werden, wodurch eine hohe Flexibilität hinsichtlich der Nutzung der Induktivität in Bezug auf das Einstellen der Schalteigenschaften des Schaltelements für unterschiedlichste Schaltfunktionen zur Verfügung steht.

Durch die Erfindung ist es somit insgesamt möglich, eine große Flexibilität hinsichtlich des Einstellens der Schalteigenschaften des Schaltelements insbesondere während des bestimmungsgemäßen Schaltbetriebs des Schaltelements realisieren zu können. Sogar während des Schaltbetriebs können diese Schalteigenschaften in geeigneter Weise angepasst werden. Dabei erlaubt die Erfindung eine große Flexibilität hinsichtlich der Einstellbarkeit, sodass eine nahezu beliebige Einstellbarkeit der Schalteigenschaften, insbesondere kontinuierlich aber auch diskret, zum Beispiel in vorgebbaren Stufen, erreicht werden kann. Dabei kommt die Erfindung mit einer sehr geringen Anzahl von Bauelementen aus, sodass sie sehr kostengünstig realisiert werden kann.

Weiterhin wird vorgeschlagen, dass Signalpegel für einen eingeschalteten Schaltzustand des zweiten und des dritten Schaltsignals zueinander zeitlich versetzt sind. Hierdurch kann erreicht werden, dass ein Kurzschluss der Steuerspannungsquelle vermieden wird, wenn nämlich das zweite und das dritte Steuerschaltelement gleichzeitig eingeschaltet sind.

Darüber hinaus wird vorgeschlagen, dass Signalpegel für einen eingeschalteten Schaltzustand des ersten und des vierten Schaltsignals zeitlich zueinander versetzt sind. Auch hier kann erreicht werden, dass ein Kurzschluss der Steuerspannungsquelle vermieden wird.

Ferner wird vorgeschlagen, dass sich Signalpegel für einen eingeschalteten Schaltzustand des ersten und des dritten Schaltsignals zumindest teilweise zeitlich überlappen. Hierdurch kann erreicht werden, dass der Energieinhalt der Induktivität für das Wechseln des Schaltelements vom ausgeschalteten Schaltzustand in den eingeschalteten Schaltzustand eingestellt werden kann. Der Energieinhalt der Induktivität ist dabei vorzugsweise abhängig von der zeitlichen Überlappung der Signalpegel für den eingeschalteten Schaltzustand. Dadurch kann das erste und das zweite Steuerschaltelement dazu genutzt werden, die Induktivität für das Einschalten des Schaltelements mit der vorgegebenen Energie aufzuladen.

Es wird weiterhin vorgeschlagen, dass sich Signalpegel für einen eingeschalteten Schaltzustand des dritten und des vierten Schaltsignals zumindest teilweise zeitlich überlappen. Hier kann die Induktivität mit einer vorgegebenen Energiemenge für den Wechsel des Schaltelements vom eingeschalteten Schaltzustand in den ausgeschalteten Schaltzustand beaufschlagt werden. Der Energieinhalt der Induktivität kann hier abhängig von der zeitlichen Überlappung eingestellt werden.

Ferner wird vorgeschlagen, dass die Signalpegel für das erste und das zweite Schaltsignal in Bezug auf einen Wechsel von einem ausgeschalteten Schaltzustand zu einem eingeschalteten Schaltzustand gleich sind. Vorzugsweise sind das erste und das zweite Steuerschaltelement dann im eingeschalteten Schaltzustand, sodass die Induktivität mit der vorgegebenen Energie aufgeladen werden kann. Der eigentliche Einschaltvorgang des Schaltelements beginnt dann damit, dass das zweite Steuerschaltelement in den ausgeschalteten Schaltzustand mittels des zweiten Schaltsignals geschaltet wird, wobei das erste Steuerschaltelement weiterhin im eingeschalteten Schaltzustand verbleibt. Die Energie der Induktivität wird dann der Gate-Kapazität des Schaltelements zugeführt. Entsprechendes kann für das dritte und das vierte Schaltelement vorgesehen sein, wenn ein Wechsel vom eingeschalteten Zustand zum ausgeschalteten Schaltzustand des Schaltelements erfolgen soll.

Es wird ferner vorgeschlagen, dass eine Zeitdauer eines einen eingeschalteten Schaltzustand des zweiten Schaltsignals repräsentierenden Signalpegels kürzer als eine Zeitdauer eines einen eingeschalteten Schaltzustand des ersten Schaltsignals repräsentierenden Signalpegels ist. Insbesondere wenn das erste und das zweite Schaltsignal im Wesentlichen zeitgleich einen Signalpegel für den eingeschalteten Schaltzustand der entsprechenden Steuerschaltelemente einnimmt, kann dadurch erreicht werden, dass während der Zeitdauer, während der nur das erste Steuerschaltelement im eingeschalteten Schaltzustand ist, der Schaltvorgang des Schaltelements in vorgebbarer Weise ausgeführt werden kann. Während dieser Phase kann dann die Energie der Induktivität der Gate-Kapazität des Schaltelements zugeführt werden. Das erste Schaltelement ist deshalb vorzugsweise wenigstens so lange im eingeschalteten Schaltzustand, bis die Gate-Kapazität in vorgegebener Weise umgeladen worden ist.

Darüber hinaus wird vorgeschlagen, dass eine Zeitdauer eines einen eingeschalteten Schaltzustand des dritten Schaltsignals repräsentierenden Signalpegels kürzer als eine Zeitdauer eines einen eingeschalteten Schaltzustand des vierten Schaltsignals repräsentierenden Signalpegels ist. Hierdurch kann erreicht werden, dass, insbesondere wenn das dritte und das vierte Schaltsignal den eingeschalteten Schaltzustand im Wesentlichen zeitgleich einnehmen, nach Abschalten des dritten Steuerschaltelements durch das dritte Schaltsignal der Umladevorgang für die Gate-Kapazität zum Ausschalten des Schaltelements durchgeführt werden kann. Die Zeitdauer für den eingeschalteten Schaltzustand des vierten Schaltsignals ist dabei vorzugsweise derart gewählt, dass der Umladevorgang der Gate-Kapazität zuverlässig ausgeführt werden kann.

Gemäß einer Weiterbildung wird vorgeschlagen, dass das erste und das vierte Steuerschaltelement zumindest zeitweise derart im Schaltbetrieb betrieben werden, dass eine Synchronwandlung bezüglich des Steuerns der Spannung am Steueranschluss erreicht wird. Dadurch kann ein gewünschtes Potential am Steueranschluss auch bei einer ungünstigen Versorgungsspannung für die Treiberschaltung erreicht werden. Ein Wert der Versorgungsspannung für die Treiberschaltung braucht also nicht auf das für den jeweiligen Schaltzustand gewünschte Potential abgestimmt zu sein. Durch diese Steuerung der Treiberschaltung kann somit eine entsprechende Anpassung erreicht werden. Beispielsweise kann für den eingeschalteten und/oder den ausgeschalteten Schaltzustand eine entsprechende Regelung des Potentials am Steueranschluss des Schaltelements erreicht werden. So kann zum Beispiel eine Gate-Spannung bei einem IGBT oder einem MOSFET im eingeschalteten und/oder den ausgeschalteten Schaltzustand nachgestellt werden, wenn sich diese in unerwünschter Weise ändert oder die Versorgungsspannung für die Treiberschaltung nicht die erforderliche Stabilität aufweist oder dergleichen. Zu diesem Zweck kann mittels der Treiberschaltung eine Funktionalität des Hochsetzstellens (Booster) oder auch des Tiefsetzstellens (Buck) realisiert werden. Diese Funktionalität braucht nicht permanent aktiviert zu sein. Es kann vorgesehen sein, dass diese Funktionalität nur für einen vorgebbaren Zeitraum im eingeschalteten und/oder den ausgeschalteten Schaltzustand aktiviert ist.

Die für die erfindungsgemäße Treiberschaltung angegebenen Vorteile und Wirkungen gelten natürlich gleichermaßen auch für den mit der erfindungsgemäßen Treiberschaltung ausgerüsteten Energiewandler sowie für das Verfahren der Erfindung und umgekehrt. Infolgedessen können Vorrichtungsmerkmale natürlich auch als Verfahrensmerkmale und umgekehrt formuliert sein.

Weitere Vorteile und Merkmale ergeben sich aus der folgenden Beschreibung von Ausführungsbeispielen anhand der beigefügten Figuren. In den Figuren bezeichnen gleiche Bezugszeichen gleiche Merkmale und Funktionen. Es zeigen:
- FIG 1: in einer schematischen Blockschaltbilddarstellung einen Hochsetzsteller als Energiewandler mit einem durch eine Treiberschaltung gesteuerten IGBT als Schaltelement,
- FIG 2: eine schematische vereinfachte Blockschaltbilddarstellung für eine Gate-Ansteuerung des IGBT nach FIG 1,
- FIG 3: eine schematische Diagrammdarstellung bezüglich Schalteigenschaften abhängig von der GateAnsteuerung,
- FIG 4: eine schematische Schaltbilddarstellung für eine resistive Gate-Ansteuerung,
- FIG 5: eine schematische Schaltbilddarstellung für eine Weiterbildung der resistiven Gate-Ansteuerung gemäß FIG 4,
- FIG 6: eine schematische Schaltbilddarstellung für eine Weiterentwicklung der resistiven Gate-Ansteuerung gemäß FIG 4 mit einer bipolaren Steuerspannungsquelle,
- FIG 7: eine schematische Schaltbilddarstellung gemäß FIG 6 mit einem Impedanzelement, welches einen Zweig aus elektrischen Widerständen und einer Diode umfasst,
- FIG 8: eine schematische Schaltbilddarstellung gemäß einer gesteuerten Gate-Ansteuerung,
- FIG 9: eine schematische Schaltbilddarstellung für eine geregelte Gate-Ansteuerung,
- FIG 10: eine schematische Schaltbilddarstellung für eine resonante Gate-Ansteuerung für einen MOSFET zum treiberseitigen Energiesparen in einer ersten Version,
- FIG 11: eine schematische Schaltbilddarstellung wie FIG 10 in einer zweiten Version,
- FIG 12: eine schematische Diagrammdarstellung für einen Energietransfer der Gate-Ansteuerungen gemäß der FIG 10 und 11,
- FIG 13: eine schematische Schaltbilddarstellung für eine Treiberschaltung mit einer Induktivität als Impedanzelement und einer H-Brückenschaltung von Steuerschaltelementen, und
- FIG 14: eine schematische Diagrammdarstellung zur Funktion der Treiberschaltung gemäß FIG 13 bezüglich eines Einschaltvorgangs des IGBTs, wobei die Induktivität vor dem Einschalten des IGBTs mit einer vorgegebenen Energiemenge aufgeladen wird, wobei mittels eines Graphen eine Gate-Spannung dargestellt wird.
- FIG 15: eine schematische Diagrammdarstellung zur Funktion der Treiberschaltung gemäß FIG 13 bezüglich eines Einschaltvorgangs des IGBTs, wobei die Induktivität vor dem Einschalten des IGBTs mit einer vorgegebenen Energiemenge aufgeladen wird, wobei mittels eines Graphen ein Gate-Strom dargestellt wird.
- FIG 16: eine schematische Diagrammdarstellung zur Funktion der Treiberschaltung gemäß FIG 13 bezüglich eines Einschaltvorgangs des IGBTs, wobei die Induktivität vor dem Einschalten des IGBTs mit einer vorgegebenen Energiemenge aufgeladen wird, wobei mittels eines Graphen ein Induktivitätsstrom dargestellt wird.

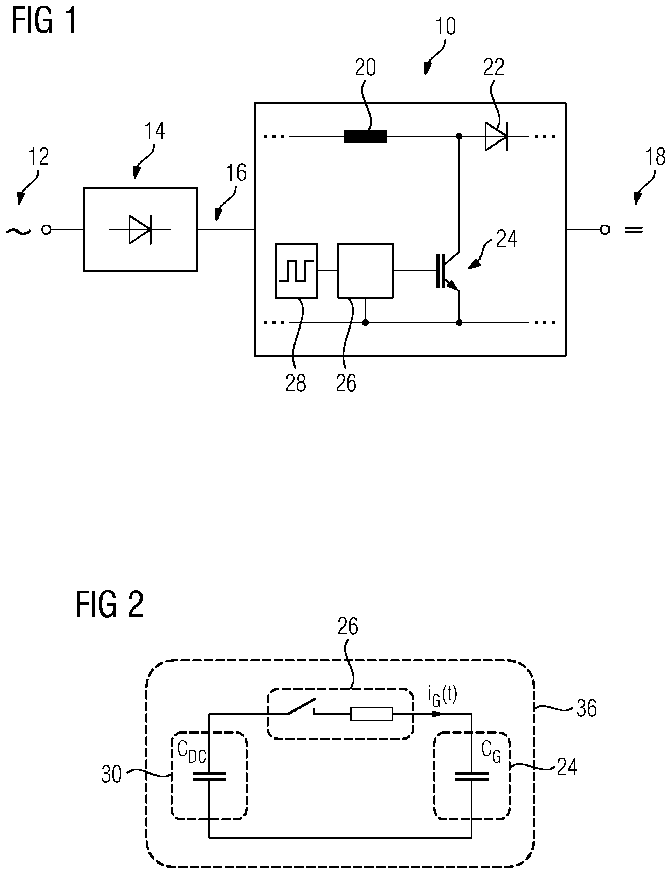

FIG 1 zeigt in einer schematischen Blockschaltbilddarstellung in vereinfachter Form ein nicht bezeichnetes Netzteil als Energiewandler, welches einen Hochsetzsteller 10 umfasst, mittels welchem eine Wechselspannung 12 gewandelt wird, um eine Gleichspannung 18 bereitzustellen. Die Wechselspannung 12 ist vorliegend eine Netzwechselspannung eines öffentlichen Energieversorgungsnetzes und beträgt in diesem Beispiel etwa 230 V bei etwa 50 Hz. Die bereitgestellte Gleichspannung 18 beträgt vorliegend etwa 450 V. Die Werte können natürlich bedarfsweise variieren.

Das Netzteil umfasst eine Gleichrichtereinheit 14, mittels der die Wechselspannung 12 in eine pulsierende Gleichspannung 16 gewandelt wird. Diese wird einem Hochsetzsteller 10 als Energiewandler zugeführt, der dann die Gleichspannung 18 entsprechend bereitstellt.

Der Hochsetzsteller 10 umfasst eine Wandlerinduktivität 20, die zu einem IGBT 24 als Schaltelement in Reihe geschaltet ist. An einem Verbindungspunkt der Wandlerinduktivität 20 mit dem IGBT 24 ist eine Anode einer Diode 22 angeschlossen, an deren Kathode die Gleichspannung 18 bereitgestellt werden kann.

Zur Ansteuerung eines Schaltelements, insbesondere nach Art eines Leistungshalbleiters wie des IGBT 24, eines MOSFET oder dergleichen, umfasst der Hochsetzsteller 10 eine an einen Steueranschluss des IBGT 24 angeschlossene Treiberschaltung 26, um das Schaltelement, hier den IGBT 24, in den elektrisch leitenden oder sperrenden Zustand, das heißt, den eingeschalteten Schaltzustand oder den ausgeschalteten Schaltzustand, zu versetzen. Mittels der Treiberschaltung 26 wird eine Gate-Kapazität C_{gs} des Schaltelements beziehungsweise des IGBT aufgeladen oder entladen.

Ferner umfasst der Hochsetzsteller 10 einen Taktgeber 28, der ein geeignetes Taktsignal für den Schaltbetrieb des IGBT 24 bereitstellt. Das Taktsignal wird der Treiberschaltung 26 zugeführt, damit die Treiberschaltung 26 ein entsprechendes Steuersignal am Steueranschluss des IGBT 24 bereitstellen kann.

Die Treiberschaltung 26 und der Taktgeber 28 werden von einer Steuerspannungsquelle 30 mit elektrischer Energie für den bestimmungsgemäßen betrieb versorgt. Zu diesem Zweck stellt die Steuerspannungsquelle 30 eine Gleichspannung als Steuerspannung bereit.

FIG 2 zeigt einen vereinfachten schematischen Aufbau, bei dem die Steuerspannungsquelle 30 die elektrische Energie für den bestimmungsgemäßen Betrieb der Treiberschaltung 26 bereitstellt, mittels der der Steueranschluss des Schaltelements, hier ein Gate des IGBT 24, beaufschlagt wird. Die Treiberschaltung 26 gemäß FIG 2 umfasst eine stark vereinfachte Ansteuerschaltung mittels eines nicht bezeichneten Schaltelements, welches in Reihe zu einem elektrischen Widerstand geschaltet ist. Steuerseitig ist der IGBT 24 ebenfalls reduziert dargestellt, und zwar durch einen Kondensator, der seine Gate-Kapazität C_{gs} repräsentiert.

Die Treiberschaltung 26 basiert dem Grunde nach darauf, die Steuerspannungsquelle 30 mit dem Gate-Anschluss beziehungsweise dem Gate des IGBT 24 in vorgegebener Weise zu verbinden. Zu diesem Zweck wird eine auf einen Emitter E des IGBT 24 bezogene positive elektrische Spannung zum Einschalten des IGBT 24 genutzt. Zum Ausschalten kann darüber hinaus eine geeignete negative Spannung genutzt werden.

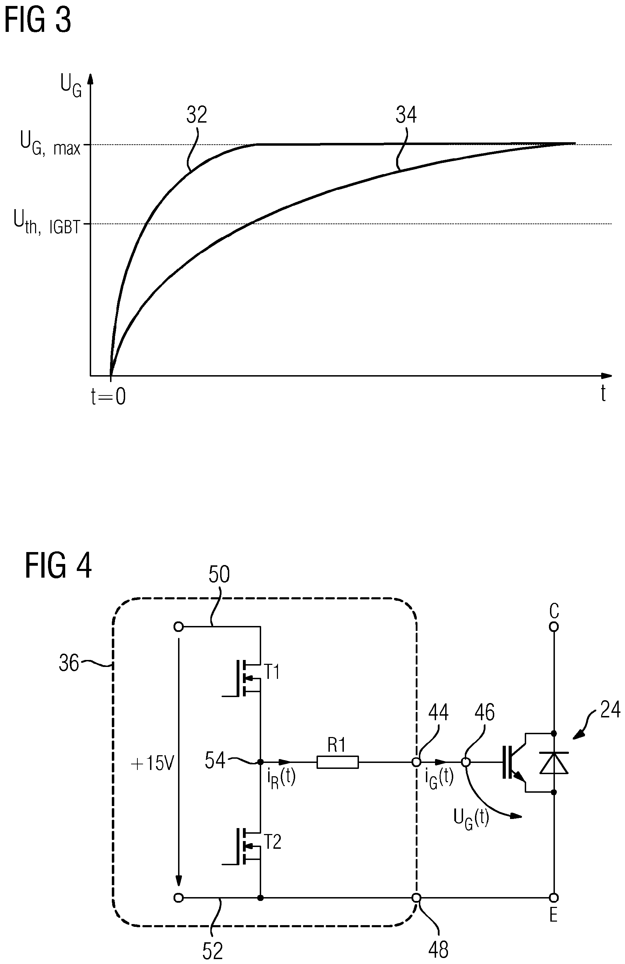

Eine entsprechende Darstellung für einen Schaltvorgang ergibt sich aus der schematischen Diagrammdarstellung gemäß FIG 3. Daraus ergibt sich, dass Schalteigenschaften des IGBT 24 durch die Treiberschaltung 36 gemäß FIG 2 beeinflusst werden können.

In dem Diagramm gemäß FIG 3 ist eine Abszisse der Zeit t zugeordnet, wohingegen eine Ordinate einer elektrischen Spannung U_{G} am Gate-Anschluss beziehungsweise Steueranschluss des IGBT 24 darstellt. Mit U_{G,max} ist mit einer gepunkteten Linie ein Wert für eine maximale Gate-Spannung U_{G,max} im eingeschalteten Schaltzustand des IGBT 24 dargestellt, die während des eingeschalteten Schaltzustands im Wesentlichen am Gate-Anschluss anliegt. Mit U_{th,IGBT} ist eine weitere Spannung angegeben, die eine spezifische Spannung des IGBT ist und die einen Wert angibt, bei dem der IGBT zwischen dem eingeschalteten Schaltzustand und dem ausgeschalteten Schaltzustand wechselt, also einen Schaltpunkt angibt. Mit Graphen 32, 34 sind zeitliche Verläufe der Spannung am Gate-Anschluss des IGBT 24 dargestellt, die abhängig von einem jeweils gewählten Wert eines elektrischen Widerstands des Impedanzelements der Treiberschaltung 26 sind. Der Graph 32 repräsentiert ein Aufladen der Gate-Kapazität C_{gs} bei einem kleinen Widerstandswert, wohingegen der Graph 34 das Aufladen der Gate-Kapazität C_{gs} bei einem großen Widerstandswert darstellt. Die Kurven basieren auf der Schaltung gemäß FIG 2.

Zu erkennen ist, dass der Graph 32 den Spannungswert U_{th,IGBT} zu einem deutlich früheren Zeitpunkt als der Graph 34 erreicht. Dadurch ist ersichtlich, dass der IGBT 24 gemäß dem Graphen 32 früher einschaltet als gemäß dem Graphen 34, weil der Wert U_{th,IGBT} früher erreicht wird. Das Schaltverhalten des IGBT 24 hängt also unter anderem davon ab, wie schnell seine Gate-Kapazität C_{gs} umgeladen wird. Dies kann durch die Treiberschaltung 36 beeinflusst werden, wie dies im Folgenden noch ausgeführt wird.

Der IGBT 24 bildet vorliegend das Schaltelement, dessen Schaltstrecke an einem Kollektor C sowie einem Emitter E angeschlossen ist. Parallel zur Schaltstrecke ist eine Inversdiode angeschlossen, die vorliegend aber nicht bezeichnet ist. Der elektrisch isolierende Steueranschluss des IGBT 24 ist durch seinen Gate-Anschluss 46 gebildet.

Eine häufig eingesetzte Methode zur Steuerung des IGBT 24 ist die sogenannte resistive Ansteuerung. Hierbei wird zum Aufladen beziehungsweise zum Entladen der Gate-Kapazität C_{gs} die Steuerspannungsquelle 30 über ein Impedanzelement, hier ein elektrischer Widerstand R₁, an einen Gate-Anschluss 46 des IGBT 24 angeschlossen. Die Schalteigenschaften des zu schaltenden IGBT 24 lassen sich abhängig von der Steuerspannungsquelle 30 und dem Widerstand R₁ beeinflussen. Der Widerstand R₁ ist an die Steuerspannungsquelle 30 über einen Mittelanschluss 54 von zwei in Reihe geschalteten Steuerschaltelemente T₁, T₂ angeschlossen. Die Reihenschaltung ist an ein Einschaltpotential 50 und ein Ausschaltpotential 52 der Steuerspannungsquelle 30 angeschlossen. Die Steuerspannung beträgt vorliegend etwa 15 V, wobei das Ausschaltpotential 52 über einen Bezugspotentialanschluss 48 der Treiberschaltung 36 mit dem Emitter-Anschluss E des IGBT 24, der hier eine Bezugsanschluss seiner Schaltstrecke bildet, elektrisch verbunden ist.

Eine Variante gemäß der resistiven Ansteuerung zeigt FIG 4 in einer schematischen Schaltbilddarstellung. Der IGBT 24 ist als Schaltelement in einer nicht weiter dargestellten Schaltung eines ebenfalls nicht dargestellten Energiewandlers eingesetzt. Der IGBT 24 wird im Schaltbetrieb betrieben. Vorliegend ist wieder eine nicht weiter dargestellte unipolare Steuerspannungsquelle 30 vorgesehen, die zwei elektrische Potentiale bereitstellt, nämlich ein Einschaltpotential 50 sowie ein Ausschaltpotential 52, zwischen denen vorliegend eine elektrische Gleichspannung von etwa 15 V ausgebildet ist. Die nicht dargestellte Steuerspannungsquelle 30 ist Bestandteil der Treiberschaltung 36, die einen Schaltelementanschluss 44 aufweist, der unmittelbar an den Gate-Anschluss 46 des IGBT 24 angeschlossen ist. Darüber hinaus ist das Ausschaltpotential 52 auf einen Bezugspotentialanschluss 48 geführt, der unmittelbar an einen Emitter-Anschluss E des IGBT 24 angeschlossen ist. Ein Kollektor-Anschluss C des IGBT 24 ist vorliegend in nicht dargestellter Weise an weitere Schaltungskomponenten des Energiewandlers angeschlossen.

Zwischen dem Einschaltpotential 50 und dem Ausschaltpotential 52 ist eine Reihenschaltung aus zwei MOSFET T₁, T₂ als Steuerschaltelementen angeschlossen. Diese werden in nicht dargestellter Weise mit entsprechenden ersten und zweiten Schaltpotentialen beaufschlagt. Ein durch die in Reihe geschalteten MOSFET T₁, T₂ gebildeter Mittelanschluss 54 ist über ein Impedanzelement, das vorliegend durch den elektrischen Widerstand R₁ gebildet ist, an dem Schaltelementanschluss 44 angeschlossen.

Im bestimmungsgemäßen Schaltbetrieb des IGBT 24 sind die MOSFETs T₁, T₂, die vorliegend Steuerschaltelemente bilden, wechselweise eingeschaltet. Damit der IGBT 24 seinen eingeschalteten Schaltzustand einnimmt, wird der MOSFET T₁ ebenfalls eingeschaltet. Während dieses Zeitraums ist der MOSFET T₂ ausgeschaltet. Es ergibt sich eine Ladekurve für die elektrische Spannung zwischen dem Gate-Anschluss 46 und dem Emitter-Anschluss E, wie es in FIG 3 dargestellt ist. Der Verlauf gemäß einer jeweiligen der Kurven 32, 34 oder abweichend hiervon kann mittels des elektrischen Widerstands R₁ eingestellt werden. Darüber hinaus bestehen Einstellungsmöglichkeiten dadurch, dass ein Wert der elektrischen Spannung der Steuerspannungsquelle 30 eingestellt wird. Zum Ausschalten des IGBT 24 wird der MOSFET T₁ ausgeschaltet und stattdessen der MOSFET T₂ eingeschaltet. Die Gate-Kapazität C_{gs} des IGBT 24 wird somit über den elektrischen Widerstand R₁ und den MOSFET T₂ entladen.

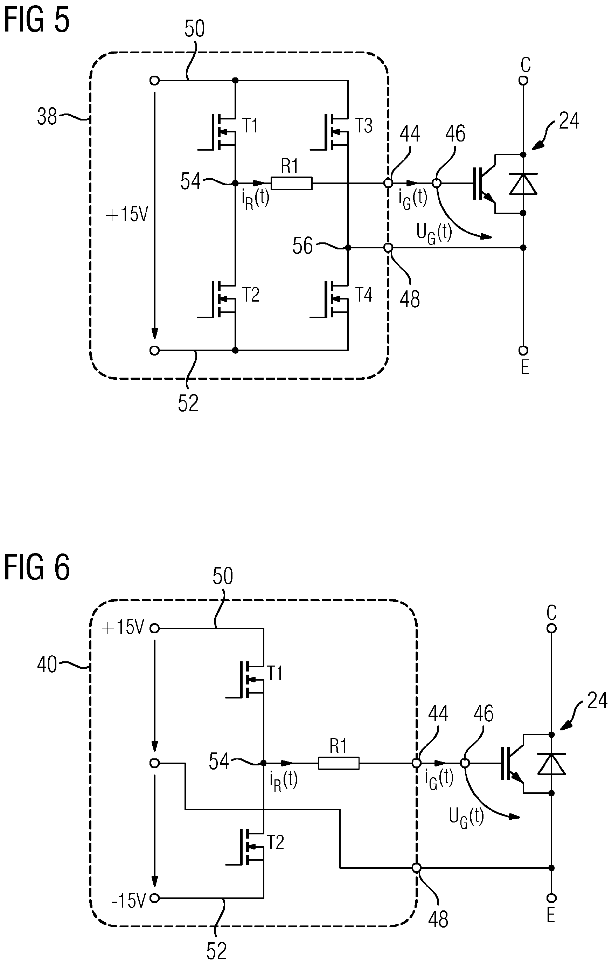

FIG 5 zeigt eine schematische Schaltbilddarstellung einer Treiberschaltung 38 ausgehend von der Ausgestaltung gemäß FIG 4, bei der zwischen dem Einschaltpotential 50 und dem Ausschaltpotential 52 eine weitere Reihenschaltung aus zwei MOSFETs T₃ sowie T₄ als Steuerschaltelementen angeschlossen ist. An einem durch diese Reihenschaltung gebildeten Mittelabgriff 56 ist der Bezugspotentialanschluss 48 angeschlossen.

Diese Ausgestaltung der Treiberschaltung 38 erlaubt es, den Gate-Anschluss 46 im ausgeschalteten Schaltzustand des IGBT 24 mit einem negativen elektrischen Potential gegenüber dem Emitter-Anschluss E zu beaufschlagen. Zu diesem Zweck werden die MOSFETs T₃ und T₄ entsprechend geschaltet. Im in FIG 5 dargestellten Beispiel ist der Gate-Anschluss 46 im eingeschalteten Schaltzustand des IGBT 24 mit +15 V beaufschlagt, wohingegen der Gate-Anschluss 46 im ausgeschalteten Schaltzustand des IGBT 24 mit einer elektrischen Spannung von -15 V gegenüber dem Emitter-Anschluss E beaufschlagt ist. Hierdurch können weitere Variationen in Bezug auf das Schaltverhalten des IGBT 24 erreicht werden.

FIG 6 zeigt in einer schematischen Schaltbilddarstellung eine weitere Ausgestaltung für eine Treiberschaltung 40, die auf den zuvor diskutierten Ausgestaltungen der Treiberschaltungen 36, 38 gemäß der FIG 4 und 5 basiert. In dieser Ausgestaltung ist die Steuerspannungsquelle 30 ausgebildet, in Bezug auf den Bezugspotentialanschluss 48 eine symmetrische Steuerspannung bereitzustellen. Das Einschaltpotential 50 hat somit weiterhin einen Wert wie in den vorhergehenden Ausgestaltungen, wobei jedoch das Ausschaltpotential 52 einen entsprechend negativen Wert gegenüber dem Bezugspotentialanschluss 48 aufweist. Dadurch kann der Gate-Anschluss 46 auf einfache Weise bipolar mit Spannung beaufschlagt werden, wie sich dies bereits anhand der Treiberschaltung 38 aus FIG 5 ergeben hat.

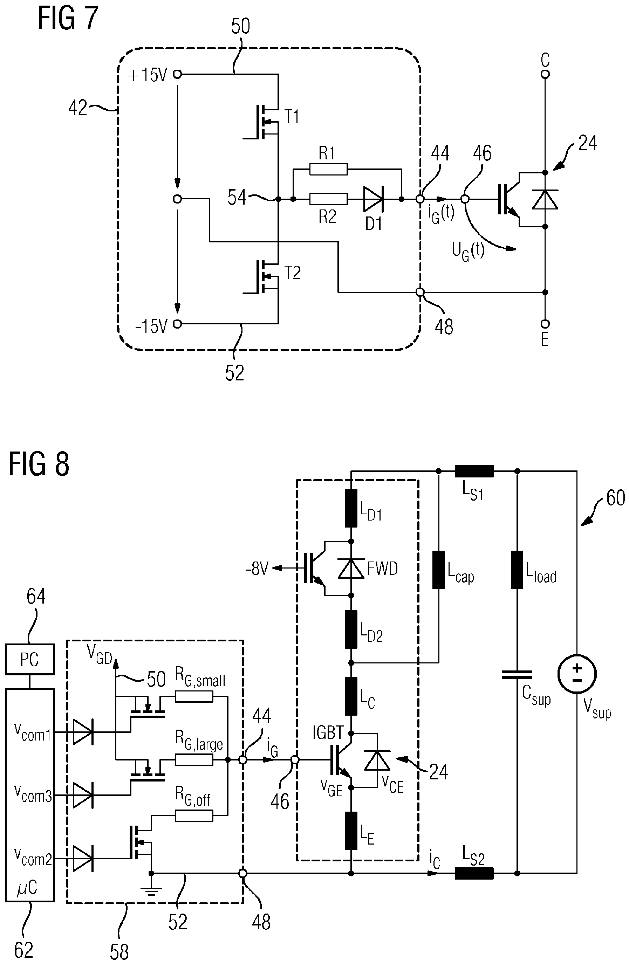

FIG 7 zeigt eine weitere Ausgestaltung für eine Treiberschaltung 42, die auf der Ausgestaltung gemäß FIG 6 basiert, in einer schematischen Schaltbilddarstellung. Die Ausgestaltung der Treiberschaltung 42 gemäß FIG 7 unterscheidet sich von der Treiberschaltung 40 gemäß FIG 6 dadurch, dass das Impedanzelement, welches in der Treiberschaltung 40 gemäß FIG 6 durch den Widerstand R₁ gebildet ist, nunmehr ein Netzwerk aus elektronischen Bauteilen aufweist.

Wie aus FIG 7 ersichtlich ist, ist der Widerstand R₁ zu einer Reihenschaltung aus einem elektrischen Widerstand R₂ sowie einer Diode D₁ parallelgeschaltet. Eine Kathode der Diode D₁ ist dabei an den Schaltelementanschluss 44 angeschlossen. Dies erlaubt es, für das Einschalten sowie das Ausschalten des IGBT 24 die Schalteigenschaften in einem gewissen Umfang und unabhängig voneinander einstellen zu können.

In der Ausgestaltung der Treiberschaltung 42 gemäß FIG 7 kann der Einschaltvorgang gegenüber dem Ausschaltvorgang beschleunigt werden, weil für das Einschalten zum Widerstand R₁ der parallelgeschaltete Zweig aus dem Widerstand R₂ und der Diode D₁ aktiviert ist und sich somit ein insgesamt reduzierter Gesamtwert für den elektrischen Widerstand ergibt. Im Falle des Ausschaltens des IGBT 24 ist hingegen aufgrund der Sperrwirkung der Diode D₁ im Wesentlichen nur der Widerstand R₁ aktiv, sodass eine größere Ausschaltzeit als die Einschaltzeit erreicht werden kann.

FIG 8 zeigt eine weitere Ausgestaltung für eine Treiberschaltung 58 in einer schematischen Schaltbilddarstellung. FIG 8 zeigt darüber hinaus die Anwendung des IGBT 24 in einem Energiewandler 60. Die Funktionalität des Energiewandlers 60 wird hier nicht weiter erläutert, zumal seine Funktion dem Grunde nach bekannt ist. Der IGBT 24 wird für die Funktionalität des Energiewandlers 60 im Schaltbetrieb betrieben.

Die Treiberschaltung 58 ist mit ihrem Schaltelementanschluss 44 wieder unmittelbar an den Gate-Anschluss 46 des IGBT 24 angeschlossen. Die Steuerspannungsquelle 30 ist hier lediglich symbolisch dargestellt. Die Treiberschaltung 58 weist drei mit einem jeweiligen Anschluss an den Schaltelementanschluss 44 angeschlossene elektrische Widerstände auf, und zwar R_{G,small}, R_{G,large} sowie R_{G,off}. Diese elektrischen Widerstände sind mit ihren jeweiligen zweiten Anschlüssen an jeweilige MOSFETs T₁, T₂, T₃ angeschlossen.

Mittels der MOSFET T₁ und T₂ können die zweiten Anschlüsse der an sie angeschlossenen elektrischen Widerstände R_{G,small}, R_{G,large} mit dem Einschaltpotential 50 der Steuerspannungsquelle 30 elektrisch verbunden werden. Der elektrische Widerstand R_{G,off} kann mittels des MOSFET T₃ mit dem Ausschaltpotential 52 elektrisch gekoppelt werden. Gesteuert werden die MOSFET T₁, T₂, T₃ über nicht bezeichnete MOSFET-Treiber von einer Steuereinheit 62, die entsprechende Schaltsignale für die MOSFET T₁, T₂, T₃ bereitstellt. Die Schaltsignale werden abhängig von einer übergeordneten Steuerung 64 bereitgestellt.

Diese Art der Steuerung wird auch als gesteuerte Ansteuerung (Open-Loop) bezeichnet. Durch Auswahl des jeweiligen Widerstands beziehungsweise auch Kombinationen können somit unterschiedliche Ladevorgänge für die Gate-Kapazität C_{gs} erreicht werden. Die Schalteigenschaften des IGBTs 24 können auf diese Weise während des Betriebs geändert werden, und zwar abhängig davon, welche der MOSFET T₁, T₂ aktiviert sind. Das Ausschalten ist hier nicht variabel einstellbar vorgesehen.

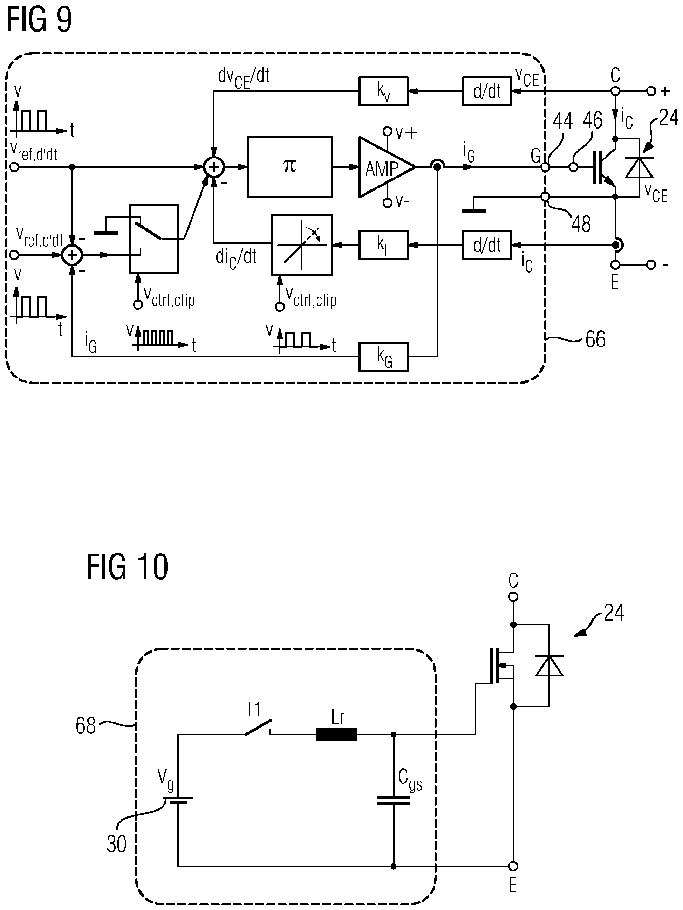

FIG 9 zeigt eine weitere Ausgestaltung mit einer Treiberschaltung 66 in einer schematischen Schaltbilddarstellung. Die Ausgestaltung gemäß FIG 9 beschreibt eine geregelte Ansteuerung (Closed-Loop), welche ein geregeltes Schalten ermöglichen soll. Die Treiberschaltung 66 basiert auf dem Prinzip eines geschlossenen Regelkreises. Hierbei wird ein Messwert einer Stromänderungsgeschwindigkeit beziehungsweise einer Spannungsänderungsgeschwindigkeit an der Schaltstrecke des IGBT 24 auf einen analogen Regler geführt, der dann das Steuersignal für den IGBT 24 entsprechend bereitstellt. Bezüglich der Funktionalität dieser Schaltung wird ferner verwiesen auf Christoph Dörlemann, "Geregelte Ansteuerung von Insulated Bipolar Transistoren (IGBT)", Dissertation Bochum 2002.

Wie aus der Darstellung gemäß FIG 9 ersichtlich ist, steuert eine Ausgangsgröße des Reglers eine Stromquelle, welche einen Gatestrom in den Gate-Anschluss 46 einprägt und so das Laden der Gate-Kapazität C_{gs} des IGBT 24 beeinflussen kann. Dadurch kann durch eine Vorgabe eines variablen Soll-Wertes für den analogen Regler die Schaltgeschwindigkeit des IGBT 24 durch Regelung seiner Gatespannung verändert werden.

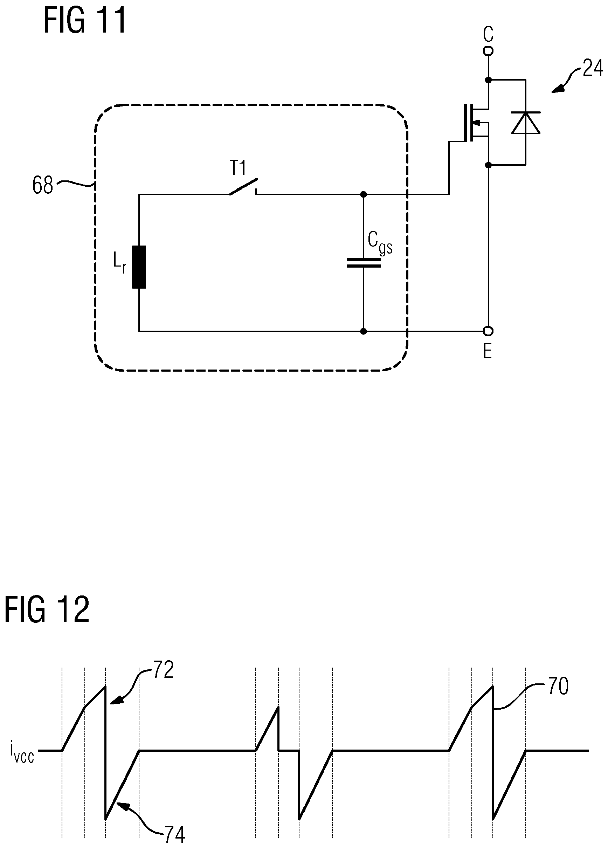

Um insbesondere bei hohen Taktraten Verluste ansteuerseitig zu reduzieren, kann eine Treiberschaltung 68 gemäß der schematischen Schaltbilddarstellung nach FIG 10 eingesetzt werden. Bei der Treiberschaltung 68 handelt es sich um eine resonante Ansteuerung, wie sie insbesondere bei schnellschaltenden Schaltnetzteilen mit Taktraten von größer als 100 kHz zum Einsatz kommen kann. Verluste, die insbesondere bei Nutzung von elektrischen Widerständen auftreten können, können somit reduziert beziehungsweise vermieden werden. FIG 10 zeigt das Prinzip unter Nutzung eines parallelen Schwingkreises. FIG 11 zeigt eine entsprechende schematische Schaltbilddarstellung der Treiberschaltung 68 unter Nutzung eines parallelen Schwingkreises. Der Schwingkreis umfasst unter anderem eine Gate-Kapazität C_{gs} sowie eine Gate-Induktivität Lᵣ. Das Prinzip des resonanten Ansteuerns liegt dem Grunde nach darin, die Ladung, welche benötigt wird, um die Gate-Kapazität C_{gs} aufzuladen oder zu entladen, zwischen der Gate-Kapazität C_{gs} und der Energiequelle hin und her schwingen zu lassen.

FIG 12 zeigt in einer schematischen Diagrammdarstellung mit einem Graphen 70 den entsprechenden Schwingvorgang der Energie. Zu diesem Zweck ist eine Ordinate einem Strom der Stromquelle zugeordnet, wohingegen die Abszisse der Zeit zugeordnet ist. Bis zu einem Punkt 72, bei dem der Strom von einem positiven Wert auf einen negativen Wert springt, wird Energie von der Steuerspannungsquelle 30 bezogen. In einem Bereich 74 wird hingegen die Energie zur Steuerspannungsquelle 30 zurückgeliefert. Diese Vorgänge wiederholen sich zyklisch für jeden Schaltwechsel.

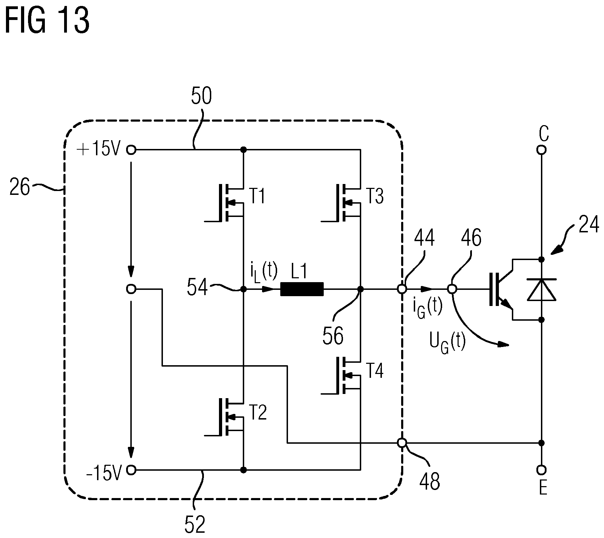

FIG 13 zeigt nun in einer schematischen Schaltbilddarstellung eine Treiberschaltung 26 gemäß der Erfindung, die es erlaubt, die Schalteigenschaften des IGBT 24 während des bestimmungsgemäßen Schaltbetriebs an einen aktuellen Arbeitspunkt oder ein gewünschtes Schaltverhalten anpassen zu können. Zu diesem Zweck sind MOSFET T₁ bis T₄ als Steuerschaltelemente nach Art einer Vollbrückenschaltung vorgesehen, bei denen jeweils zwei MOSFET T₁, T₂ sowie T₃, T₄ jeweils paarweise in Reihe geschaltet zueinander angeordnet sind. Jede der Reihenschaltungen ist an das Einschaltpotential 50 und das Ausschaltpotential 52 angeschlossen.

Zwischen durch die Reihenschaltungen ausgebildeten Mittelanschlüssen 54, 56 ist als Impedanzelement eine Induktivität L₁ angeschlossen. Darüber hinaus ist der Mittelanschluss 56 an dem Schaltelementanschluss 44 der Treiberschaltung 26 angeschlossen. Wie in den vorhergehenden Ausführungsbeispielen erläutert, ist der Schaltelementanschluss 44 unmittelbar an den Gate-Anschluss 46 des IGBT 24 angeschlossen. Diesbezüglich wird auf die vorhergehenden Ausführungen verwiesen.

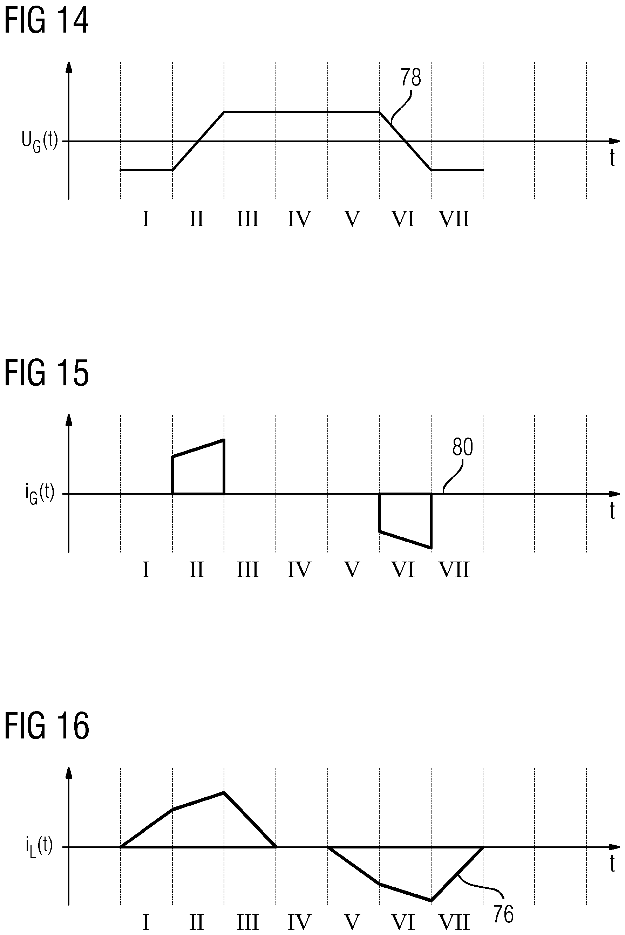

Die Steuerspannungsquelle 30 ist vorliegend bipolar ausgebildet, wie es bereits zur Treiberschaltung 40 gemäß FIG 6 erläutert wurde. Diesbezüglich wird deshalb auf diese Ausführungen verwiesen. Mit dem schematischen Diagramm 14 werden beispielhaft Vorgänge für das Einschalten und das Ausschalten des IGBT 24 schematisch dargestellt. In den Diagrammen gemäß FIG 14 bis 16 sind jeweilige Graphen 76, 78, 80 dargestellt, wobei die Abszisse in sämtlichen der Diagramme gemäß der FIG 14 bis 16 jeweils der Zeit zugeordnet ist. Die Zeitachsen der FIG 14 bis 16 entsprechen einander.

In FIG 14 ist schematisch mit einem Graphen 78 eine Gate-Spannung U_{G} zwischen dem Gate-Anschluss 46 sowie dem Emitter-Anschluss E des IGBT 24 dargestellt. Ein Graph 80 in FIG 15 stellt den elektrischen Gate-Strom dar, mit dem der Gate-Anschluss 46 beaufschlagt wird. Ein Graph 76 in FIG 16 stellt den Indutivitätsstrom dar, mit dem die Induktivität L₁ beaufschlagt ist.

Um den IGBT 24 einzuschalten beziehungsweise den eingeschalteten Schaltzustand einnehmen zu können, muss seine Gate-Kapazität C_{gs} aufgeladen werden. Zu diesem Zweck werden mittels entsprechender Schaltsignale die MOSFET T₁, T₄ als Steuerschaltelemente gemäß einer Phase I in den FIG 14 bis 16 eingeschaltet. Wie der Graph 76 zeigt, steigt der Strom durch die Induktivität L₁ entsprechend an. Die Induktivität L₁ speichert also Energie. In diesem Zeitraum ist der Gate-Strom gemäß dem Graphen 80 jedoch noch null.

Nachdem ein vorgegebener Energieinhalt durch die Induktivität L₁ am Ende der Phase I erreicht ist, wird für eine Phase II der MOSFET T₄ mittels des ihm zugeordneten Schaltsignals ausgeschaltet. Der durch die Induktivität L₁ strömende Strom strömt nunmehr in die Gate-Kapazität C_{gs}, weshalb er während dieser Phase im Wesentlichen dem Strom am Gate-Anschluss 46 entspricht. Der Gate-Strom entsprich nun dem Induktivitätsstrom wie sich anhand der Graphen 74 und 76 in den FIG 15 und 16 ergibt.

In dieser Zeit ändert sich auch die Gate-Spannung U_{G} gemäß dem Graphen 78 in FIG 14 und erreicht am Ende der Phase II den maximalen Wert für den eingeschalteten Schaltzustand des IGBT 24. Abhängig von der in der Induktivität L₁ gespeicherten Energie und des damit verbundenen elektrischen Stroms, der durch die Induktivität L₁ fließt, schaltet der IGBT 24 schneller oder langsamer ein, weil sich die Ladung der Gate-Kapazität C_{gs} und damit auch die Gate-Spannung U_{G} entsprechend schneller oder langsamer ändert. Der IGBT 24 ist nun im eingeschalteten Schaltzustand.

An die Phase II schließt sich eine Phase III an, in der die Induktivität L₁ entladen wird. Dies ist anhand des Graphen 76 in FIG 16 ersichtlich, der anzeigt, dass der entsprechende Strom durch die Induktivität L₁ am Ende der Phase III 0 wird. Erreicht wird dies dadurch, dass hier nun auch der MOSFET T₁ ausgeschaltet wird. Die restliche Energie der Induktivität L₁ entlädt sich dann über nicht dargestellte integrierte Inversdioden der MOSFET T₂, T₃, sodass sie der Steuerspannungsquelle 30 wieder zugeführt wird.

Wenn die in der Induktivität L₁ gespeicherte Energie genau der Energie entspricht, die zum Umladen der Gate-Kapazität C_{gs} erforderlich ist, ist ein Spulenstrom i_{L} durch die Induktivität L₁ am Ende der Phase II bereits null. Durch entsprechendes Vorgeben des Energieinhalts der Induktivität L₁ kann somit auch die Charakteristik hinsichtlich des Umladens der Gate-Kapazität C_{gs} des IGBT 24 gesteuert werden, sodass seine Schalteigenschaften entsprechend beeinflusst werden können.

Abhängig von der in der Induktivität L₁ gespeicherten Energie und des damit verbundenen Spulenstromes i_{L} schaltet der IGBT 24 schneller oder langsamer ein. Durch die Veränderung der Schaltzeiten der Schaltsignale für die einzelnen MOSFET T₁ bis T₄ kann somit die Zeit, in der die Induktivität L₁ vorgeladen wird, entsprechend angepasst werden. Somit ist die Energie, welche beim Umladen in die Gate-Kapazität C_{gs} des IGBT 24 bereits in der Induktivität L₁ gespeichert ist, variabel, insbesondere einstellbar. Je größer also der Spulenstrom i_{L} am Ende der Phase I ist, desto höher ist der Gatestrom zu Beginn der Phase II. Die Fläche unter dem Graphen 76 in der Phase II ist somit ein Maß für eine Ladungsmenge, welche zum Umladen der Gate-Kapazität C_{gs} zur Verfügung steht. Es ist daher klar, dass die Schaltgeschwindigkeit des IGBT 24 dadurch beeinflusst werden kann, wie schnell die benötigte Ladung der Gate-Kapazität C_{gs} des IGBT 24 zugeführt werden kann. Je höher also der Wert des Spulenstroms i_{L} in der Phase II ist, desto kürzer kann die Zeit sein, bis die benötigte Ladungsmenge für das Umladen der Gate-Kapazität C_{gs} erreicht ist.

Um einen Endwert des Einschaltpotentials 50 am Gate-Anschluss 46 zuverlässig erreichen zu können und das Potential stabiler gegen Störeinkopplungen zu machen, wird vorliegend zu Beginn der Phase III der MOSFET T₃ eingeschaltet. Dadurch kann der stationär eingeschaltete Schaltzustand des IGBT 24 zuverlässig eingenommen und erhalten werden.

Darüber hinaus kann zum Entladen der Energie der Induktivität L₁ auch vorgesehen sein, dass in der Phase III sowohl der MOSFET T₃ als auch der MOSFET T₂ eingeschaltet sind. Sobald der Spulenstrom i_{L} der Induktivität L₁ null wird, kann der MOSFET T₂ abgeschaltet werden. Der MOSFET T₃ kann dagegen weiter eingeschaltet bleiben.

An die Phase III schließt sich eine Phase IV an, innerhalb der der IGBT 24 in seinem eingeschalteten Schaltzustand ist. Wie anhand des Graphen 78 in FIG 14 ersichtlich ist, ist das elektrische Potential am Gate-Anschluss 46 das Einschaltpotential 50.

An die Einschaltphase IV schließt sich eine Phase V an, die der Vorbereitung des Ausschaltens des IGBT 24 dient. In der Phase V ist vorgesehen, dass die Induktivität L₁ durch Einschalten der MOSFET T₂, T₃ mit einem Strom beaufschlagt wird, der dazu dient, in der Phase VI den IGBT 24 auszuschalten. Dies funktioniert dem Grunde nach ebenso wie das zuvor beschriebene Einschalten, weshalb ergänzend auf die diesbezüglichen Ausführungen verwiesen wird.

Während der Phase V wird die Induktivität L₁ reversiert mit der Steuerspannungsquelle 30 über die MOSFET T₂ und T₃ gekoppelt. Am Ende der Phase V steht ein vorgegebener Spulenstrom i_{L} der Induktivität L₁ zur Verfügung, der einem vorgegebenen Energieinhalt der Spule L₁ entspricht. Zum Entladen der Gate-Kapazität C_{gs} des IGBT 24, damit dieser vom eingeschalteten Schaltzustand in den ausgeschalteten Schaltzustand wechselt, wird zu Beginn der Phase VI der MOSFET T₃ ausgeschaltet. Der Spulenstrom i_{L} kommutiert dadurch - wie zuvor auch für den Einschaltvorgang beschrieben - auf den Gate-Anschluss 46, wodurch in der Gate-Kapazität C_{gs} gespeicherte elektrische Ladung abgeführt wird. Am Ende der Phase VI erreicht der Gate-Anschluss 46 das Ausschaltpotential 52, wie anhand des Graphen 78 in FIG 14 ersichtlich ist. Der MOSFET T₂ wird sodann ausgeschaltet. Der IGBT 24 ist nunmehr im ausgeschalteten Schaltzustand.

An die Phase VI schließt sich eine Phase VII an, bei der die restliche Energie der Induktivität L₁ wieder der Steuerspannungsquelle 30 zugeführt wird. Dies kann über die MOSFET T₁, T₄ erfolgen. Am Ende der Phase VII kann der MOSFET T₄ eingeschaltet bleiben, um den Gate-Anschluss 46 zuverlässig mit dem Ausschaltpotential 52 zu koppeln und dadurch eine verbesserte Störfestigkeit zu erreichen.

Das Prinzip des Ausschaltens entspricht somit im Wesentlichen dem Prinzip des Einschaltens. Nach dem Vorladen der Induktivität L₁ in der Phase VI wird durch Abschalten des MOSFET T₃ die Gate-Kapazität C_{gs} entladen.

Eine weitere mögliche Anwendung der beschriebenen Treiberschaltung 26 besteht im Betrieb der MOSFET T₁ und T₂ in Verbindung mit der Gate-Kapazität C_{gs} und der Induktivität L₁ als Synchronwandler, also als eine Art getakteter Gate-Treiber, um eine Regelung der Gate-Spannung U_{G} beziehungsweise des elektrischen Potentials am Gate-Anschluss 46 erreichen zu können.

Mit der Erfindung kann erreicht werden, dass Schalteigenschaften von Schaltelementen auch während des bestimmungsgemäßen Schaltbetriebs nahezu kontinuierlich geändert werden können. Da die Energie, welche in der Induktivität L₁ gespeichert wird, nahezu stufenlos eingestellt werden kann, können auch die Schalteigenschaften, insbesondere die Schaltgeschwindigkeit des Schaltelements, in einem weiten Bereich frei eingestellt werden. Somit ist eine Einstellung der Schalteigenschaften beispielsweise von einer Schaltflanke bis zur nächsten Schaltflanke nahezu individuell änderbar, ohne dabei beispielsweise Gate-Widerstände oder dergleichen tauschen oder auswählen zu müssen, wie es bei der konventionellen resistiven Ansteuerung erforderlich wäre.

Darüber hinaus besteht die Treiberschaltung 26 nur aus wenigen Bauteilen, wodurch die Komplexität der Treiberschaltung 26 klein gehalten werden kann. Im Vergleich dazu wäre eine Ansteuerung mittels eines geschlossenen Regelkreises erheblich komplexer. Diese benötigt nicht nur eine Vielzahl analoger Schaltungen, um die Schalteigenschaften gemäß diesem Prinzip einstellen zu können, sondern sie ist darüber hinaus auch anfällig für Störungen und benötigt viele Bauteile. Die Treiberschaltung 26 gemäß der Erfindung ist dagegen hinsichtlich ihrer Struktur und des Aufwands erheblich einfacher und kostengünstiger. Zugleich kann eine hohe Zuverlässigkeit erreicht werden.

Die Erfindung lässt sich somit insbesondere auch bei Energiewandlern einsetzen, bei denen entsprechende Schaltelemente in vorgegebener Weise im Schaltbetrieb gesteuert werden müssen.

Mit der Erfindung kann auf einfache Weise eine Einstellbarkeit hinsichtlich der Schalteigenschaften der Schaltelemente auch während des bestimmungsgemäßen Betriebs, insbesondere des Schaltbetriebs, erreicht werden. Energiewandler können zum Beispiel sein: Umrichter für Windkraftanlagen, Traktionsumrichter, Netzumrichter wie zum Beispiel Active-Front-End (AFE)-Umrichter, Mehrpegelumrichtermodule, Umrichter für DC/DC-Koppelstationen, Hochspannungsgleichstromübertragungs(HGÜ)-Umrichter, Bahnumrichter und dergleichen.

Die Ausführungsbeispiele dienen ausschließlich der Erläuterung der Erfindung und sollen diese nicht beschränken.

## Patentansprüche

1. Treiberschaltung (26) zum Bereitstellen eines Steuersignals für ein eine Schaltstrecke aufweisendes Schaltelement (24), das einen elektrisch isolierenden Steueranschluss (46) zum Steuern der Schaltstrecke abhängig vom Steuersignal am Steueranschluss (46) aufweist, wobei die Treiberschaltung (26) ausgebildet ist, das Steuersignal abhängig von einem Taktsignal eines Taktgebers für einen Schaltbetrieb des Schaltelements (24) bereitzustellen, zu welchem Zweck die Treiberschaltung (26) ein Impedanzelement aufweist, das einen ersten Anschluss zum Bereitstellen des Steuersignals und einen zweiten Anschluss aufweist, **dadurch gekennzeichnet, dass** das Impedanzelement eine elektrische Induktivität (L₁) aufweist und dass die Treiberschaltung (26) ein erstes und ein zweites Steuerschaltelement (T₁,T₄) aufweist und ausgebildet ist, den zweiten Anschluss des Impedanzelements mittels des ersten Steuerschaltelements (T₁) abhängig von einem ersten von dem Taktsignal abhängigen Schaltsignal mit einem Einschaltpotential (50) zu beaufschlagen und den ersten Anschluss des Impedanzelements mittels des zweiten Steuerschaltelements (T₄) abhängig von einem zweiten von dem Taktsignal abhängigen Schaltsignal mit einem Ausschaltpotential (52) zu beaufschlagen.

2. Treiberschaltung nach Anspruch 1, **gekennzeichnet durch** ein drittes Steuerschaltelement (T₃), wobei die Treiberschaltung (26) ausgebildet ist, den ersten Anschluss des Impedanzelements mittels des dritten Steuerschaltelements (T₃) abhängig von einem dritten vom Taktsignal abhängigen Schaltsignal mit dem Einschaltpotential (50) zu beaufschlagen.

3. Treiberschaltung nach einem der vorhergehenden Ansprüche, **gekennzeichnet durch** ein viertes Steuerschaltelement (T₂), wobei die Treiberschaltung (26) ausgebildet ist, den zweiten Anschluss des Impedanzelements mittels des vierten Steuerschaltelements (T₂) abhängig von einem vierten vom Taktsignal abhängigen Schaltsignal mit dem Ausschaltpotential (52)zu beaufschlagen.

4. Treiberschaltung nach einem der vorhergehenden Ansprüche, **gekennzeichnet durch** einen Schaltsignalgenerator zum Bereitstellen der Schaltsignale.

5. Energiewandler (10) zum Wandeln von elektrischer Energie, mit:
- wenigstens einem elektrischen Wandlerspeicher (20),
- wenigstens einem eine Schaltstrecke aufweisenden Schaltelement (24), das einen elektrisch isolierenden Steueranschluss (46) zum Steuern der Schaltstrecke abhängig von einem Steuersignal am Steueranschluss (46) aufweist und mit dem wenigstens einen Wandlerspeicher (20) elektrisch gekoppelt ist,
- einem Taktgeber zum Bereitstellen eines Taktsignals für einen Schaltbetrieb des wenigstens einen Schaltelements (24) und
- einer an den Steueranschluss (46) angeschlossenen und mit dem Taktgeber elektrisch gekoppelten Treiberschaltung (26), die ausgebildet ist, das Steuersignal abhängig vom Taktsignal bereitzustellen,
**dadurch gekennzeichnet, dass** die Treiberschaltung (26) nach einem der vorhergehenden Ansprüche ausgebildet ist.

6. Verfahren zum Bereitstellen eines Steuersignals für ein eine Schaltstrecke aufweisendes Schaltelement (24), das einen elektrisch isolierenden Steueranschluss (46) zum Steuern der Schaltstrecke abhängig vom Steuersignal am Steueranschluss (46) aufweist, wobei das Steuersignal abhängig von einem Taktsignal für einen Schaltbetrieb des Schaltelements (24) an einem mit dem Steueranschluss (46) elektrisch gekoppelten ersten Anschluss eines Impedanzelements bereitgestellt wird, **dadurch gekennzeichnet, dass** das Impedanzelement eine elektrische Induktivität (L₁) aufweist und dass der zweite Anschluss des Impedanzelements mittels eines ersten Steuerschaltelements (T₁) abhängig von einem ersten Schaltsignal mit einem Einschaltpotential (50) beaufschlagt wird und der erste Anschluss des Impedanzelements mittels eines zweiten Steuerschaltelements (T₄) abhängig von einem zweiten Schaltsignal mit einem Ausschaltpotential (52) beaufschlagt wird, wobei das erste und das zweite Schaltsignal abhängig vom Taktsignal bereitgestellt werden.

7. Verfahren nach Anspruch 6, **dadurch gekennzeichnet, dass** der erste Anschluss des Impedanzelements mittels eines dritten Steuerschaltelements (T₃) abhängig von einem dritten vom Taktsignal abhängigen Schaltsignal mit dem Einschaltpotential (50) beaufschlagt wird.

8. Verfahren nach Anspruch 6 oder 7, **dadurch ge**- **kennzeichnet**, dass der zweite Anschluss des Impedanzelements mittels eines vierten Steuerschaltelements (T₂) abhängig von einem vierten vom Taktsignal abhängigen Schaltsignal mit dem Ausschaltpotential (52) beaufschlagt wird.

9. Verfahren nach einem der Ansprüche 6 bis 8, **dadurch gekennzeichnet, dass** Signalpegel für einen eingeschalteten Schaltzustand des zweiten und des dritten Schaltsignals und/oder Signalpegel für einen eingeschalteten Schaltzustand des ersten und des vierten Schaltsignals zeitlich zueinander versetzt sind.

10. Verfahren nach einem der Ansprüche 6 bis 9, **da**- **durch gekennzeichnet**, dass sich Signalpegel für einen eingeschalteten Schaltzustand des ersten und des zweiten Schaltsignals zumindest teilweise zeitlich überlappen.

11. Verfahren nach einem der Ansprüche 6 bis 10, **dadurch gekennzeichnet, dass** sich Signalpegel für einen eingeschalteten Schaltzustand des dritten und des vierten Schaltsignals zumindest teilweise zeitlich überlappen.

12. Verfahren nach einem der Ansprüche 6 bis 11, **dadurch gekennzeichnet, dass** die Signalpegel für das erste und das zweite Schaltsignal in Bezug auf einen Wechsel von einem ausgeschalteten Schaltzustand zu einem eingeschalteten Schaltzustand gleich sind.

13. Verfahren nach einem der Ansprüche 6 bis 12, **dadurch gekennzeichnet, dass** eine Zeitdauer eines einen eingeschalteten Schaltzustand des zweiten Schaltsignals repräsentierenden Signalpegels kürzer als eine Zeitdauer eines einen eingeschalteten Schaltzustand des ersten Schaltsignals repräsentierenden Signalpegels ist.

14. Verfahren nach einem der Ansprüche 6 bis 13, **dadurch gekennzeichnet, dass** eine Zeitdauer eines einen eingeschalteten Schaltzustand des dritten Schaltsignals repräsentierenden Signalpegels kürzer als eine Zeitdauer eines einen eingeschalteten Schaltzustand des vierten Schaltsignals repräsentierenden Signalpegels ist.

15. Verfahren nach einem der Ansprüche 6 bis 14, **dadurch gekennzeichnet, dass** das erste und das vierte Steuerschaltelement (T₁, T₂) zumindest zeitweise derart im Schaltbetrieb betrieben werden, dass eine Synchronwandlung bezüglich des Steuerns der Spannung am Steueranschluss (46) erreicht wird.
